(19) Europäisches Patentamt
European Patent Office
Office européen des brevets

(11) Numéro de publication: **0 143 701**
**A1**

(12) **DEMANDE DE BREVET EUROPEEN**

(21) Numéro de dépôt: **84402349.9**

(22) Date de dépôt: **16.11.84**

(51) Int. Cl.[4]: **C 23 C 16/24**

(30) Priorité: **22.11.83 FR 8318568**

(43) Date de publication de la demande: **05.06.85**
**Bulletin 85/23**

(84) Etats contractants désignés: **DE GB NL**

(71) Demandeur: **THOMSON-CSF, 173, Boulevard Haussmann, F-75379 Paris Cedex 08 (FR)**

(72) Inventeur: **Proust, Nicole, THOMSON-CSF SCPI 173, bld Haussmann, F-75379 Paris Cedex 08 (FR)**
Inventeur: **Landouar, Pierre, THOMSON-CSF SCPI 173, bld Haussmann, F-75379 Paris Cedex 08 (FR)**

(74) Mandataire: **Lepercque, Jean et al, THOMSON-CSF SCPI 173, Bld Haussmann, F-75379 Paris Cedex 08 (FR)**

(54) **Procédé de dépôt de silicium amorphe par décomposition thermique à basse température, et dispositif de mise en oeuvre du procédé.**

(57) L'invention propose de déposer du silicium amorphe à basse température par décomposition thermique du disilane qui est créé en amont du réacteur thermique au cours de la même opération, de préférence par une méthode physicochimique telle que l'action de l'hydrogène atomique sur le monosilane.

L'invention s'applique notamment aux dépôts de couches de silicium amorphe dopées ou non dopées sur des substrats.

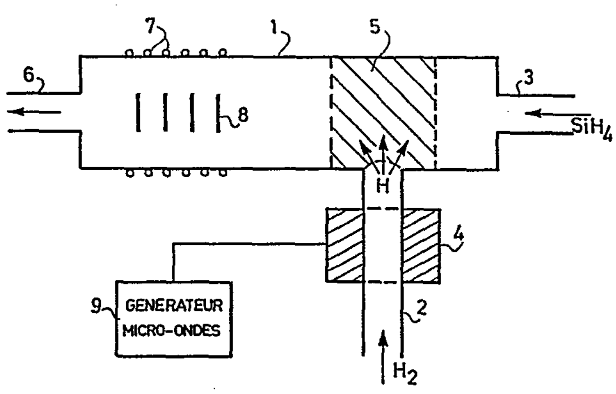


EP 0 143 701 A1

# PROCEDE DE DEPOT DE SILICIUM AMORPHE PAR DECOMPOSITION THERMIQUE A BASSE TEMPERATURE ET DISPOSITIF DE MISE EN OEUVRE DU PROCEDE

La présente invention concerne un procédé de dépôt de couches de silicium amorphe. Le procédé permet d'élaborer des couches minces de silicium amorphe et s'applique notamment à la fabrication de dispositifs de conversion photoélectrique tels que les cellules photovoltaïques, les transistors en couches minces, l'électrophotographie et les capteurs d'images.

Il existe, à ce jour, plusieurs méthodes de dépôt de silicium amorphe. Ces méthodes sont basées sur la décomposition d'un hydrure de silicium. En se décomposant, l'hydrure provoque, sur un substrat approprié et placé dans le milieu où s'effectue la décomposition, le dépôt de germes qui favorisent la croissance d'une couche de silicium amorphe.

Le dépôt de silicium amorphe à partir de silane ($Si\ H_4$) est maintenant souvent utilisé bien que l'on ne comprenne pas encore très bien le processus. Il existe plusieurs variantes. On peut décomposer thermiquement le silane à pression atmosphérique ou à pression réduite. La température à laquelle s'effectue la décomposition influe sur la vitesse de dépôt. Généralement, les réactions sont effectuées pour une température de l'ordre de 600° C. Une autre méthode de dépôt de silicium amorphe consiste en la décomposition d'un plasma de silane à pression réduite. Dans ce cas, la réaction s'effectue à une température de l'ordre de 300° C. Cette dernière méthode a l'avantage de s'effectuer à une température plus basse d'environ 300° C que les précédentes mais les produits obtenus ne sont pas identiques à cause du pourcentage d'hydrogène plus ou moins grand qu'ils contiennent.

Des travaux plus récents ont porté sur des dépôts de silicium amorphe obtenus à partir de disilane ($Si_2\ H_6$). Il est alors possible de décomposer thermiquement le disilane à pression réduite pour une température de l'ordre de 450° C. On peut aussi décomposer un plasma de disilane à une température égale ou inférieure à 350° C. Les températures de dépôt des méthodes employant le disilane ne sont pas très élevées mais l'inconvénient de ces méthodes est le prix élevé du produit de base utilisé. En effet, le silane et le

disilane sont des produits gazeux conditionnés en bouteilles vendues par les marchands de fluides et dont le rapport des prix au litre est assez considérable : un litre de disilane est environ 500 fois plus cher qu'un litre de silane. Le prix élevé des méthodes de dépôt à partir du disilane rend donc dérisoire le gain en température obtenu par la méthode de décomposition thermique.

Afin de pallier cet inconvénient, l'invention propose un procédé de dépôt de silicium amorphe par décomposition thermique du disilane créé en amont du réacteur à partir de silane.

L'invention a donc pour objet un procédé de dépôt de silicium amorphe sur un substrat, le dépôt étant réalisé dans un réacteur thermique dont la température de réaction est suffisante pour provoquer la décomposition thermique du disilane qui est produit en amont dudit réacteur thermique, caractérisé en ce que la production de disilane est obtenue au cours de l'opération de dépôt à partir d'autres éléments de base.

L'invention a aussi pour objet un dispositif de dépôt de silicium amorphe par le procédé décrit ci-dessus, caractérisé en ce qu'il est constitué par une enceinte comprenant un réacteur thermique et des moyens de chauffage.

L'invention sera mieux comprise et d'autres avantages apparaîtront au moyen de la description qui suit et des figures annexées, parmi lesquelles :

- la figure 1 représente un dispositif de dépôt de silicium amorphe par un procédé selon l'invention ;

- la figure 2 représente une variante d'un dispositif de dépôt par un procédé selon l'invention.

Le silane $SiH_4$ ou monosilane, si on réserve le terme de silane plus généralement pour les hydrures de silicium $Si_n H_{2n+2}$, permet donc des dépôts de silicium amorphes par différents procédés. Les procédés de dépôt de silicium amorphe par décomposition thermique de monosilane sont désignés par les sigles CVD (Chemical Vapor Deposition) lorsque la réaction s'effectue à pression atmosphérique, et LPCVD (Low Pressure Chemical Vapor Deposition) lorsque la réaction s'effectue pour une pression d'environ 65 pascals. Les températures de réaction sont de l'ordre de 600° C pour la méthode CVD et d'environ 565° C pour la méthode LPCVD. La vitesse de

dépôt augmente avec la température. La valeur relativement élevée de ces températures est responsable de la faible teneur en hydrogène (quelques pour cent) dans les dépôts de silicium obtenus par ces méthodes. Suivant les exigences techniques imposées pour la qualité des dépôts de silicium amorphe, on peut éventuellement effectuer une opération de post-hydrogénation à une température d'environ 400° C.

La méthode de décomposition plasma de monosilane (appelée "Glow Discharge" dans la terminologie Anglo-saxonne) s'effectue sous une pression de 1,3 Pa à quelques centaines de Pa, à une température $T_D$ 300° C. Le plasma peut être produit de différentes manière, par exemple par décharge radiofréquence ou microonde. La manière dont s'effectue la dissociation des molécules de monosilane dépend de beaucoup de paramètres : pression, température, puissance électrique de la décharge. En tout état de cause, cette méthode contribue à un apport d'hydrogène dans la structure même du dépôt de silicium et qui correspond généralement à un apport d'atomes dans le matériau déposé de l'ordre de 10 à 30% du nombre des atomes de silicium. Cet apport d'hydrogène tend à remédier aux défauts introduits par les liaisons brisées dans la masse du silicium déposé.

On a vu plus haut que le procédé de dépôt de silicium amorphe par décomposition thermique du disilane pouvait se faire à température relativement basse. Le gain en température par rapport au procédé CVD à partir de silane est de l'ordre de 150° C. Différents procédés sont utilisés pour fabriquer du disilane.

Des silanes peuvent être obtenus dans un ballon à réaction par addition de siliciure de magnésium $Mg_2$ Si à de l'acide chlorhydrique dilué. Dans cette réaction, environ 25% du silicium est transformé en un mélange de silanes comprenant 40% de $Si\,H_4$, 30% de $Si_2\,H_6$, 15% de $Si_3\,H_8$, 10% de $Si_4H_{10}$ et 5% de silanes d'ordres plus élevés. De ce mélange on peut extraire le disilane dont c'est une des méthodes de production industrielle.

Une autre méthode consiste à décomposer un plasma de monosilane qui donne des silanes d'ordres plus élevés qui sont séparés par distillation.

On peut encore obtenir du disilane par réduction de l'hydrure d'aluminium et de lithium $Al\,Li\,H_4$ par le perchlorosilane suivie d'une distillation.

Enfin, on peut effectuer une décomposition du silane induite par l'hydrogène atomique. L'hydrogène atomique peut être produit de diverses manières : par décharge radiofréquence ou microonde dans l'hydrogène moléculaire, par photosensibilisation de l'hydrogène moléculaire par le mercure ou encore par l'effet d'impulsions d'électrons de haute énergie. L'hydrogène atomique réagit avec le silane selon la réaction :

$$H + Si\,H_4 \longrightarrow Si\,H_3 + H_2 \qquad (1)$$

Dans cette réaction, $Si\,H_3$ est le radical qui contribue à la formation des produits stables obtenus qui sont $Si_2\,H_6$, $Si_3\,H_8$ et l'hydrogène moléculaire $H_2$.

Ces diverses méthodes de production de disilane peuvent être retenues dans le cadre de l'invention dont l'originalité réside dans l'utilisation immédiate qui est faite du disilane dégagé que ce soit par les méthodes chimiques ou par les méthodes physico-chimiques.

On va décrire plus précisément, et à titre non limitatif des dispositifs de mise en oeuvre du procédé selon l'invention à partir des méthodes physico-chimiques qui sont les plus pratiques.

La figure 1 représente schématiquement un dispositif de dépôt de silicium amorphe selon l'invention. Dans ce dispositif, le disilane est élaboré par action de l'hydrogène atomique sur le silane en vertu de la réaction (1). Le dispositif comprend donc deux parties : une partie où le disilane est élaboré et une partie ou s'effectue la décomposition thermique du disilane. Le dispositif est formé d'une enceinte cylindrique 1, par exemple en quartz, sur laquelle sont abouchés plusieurs conduits. Le conduit 3 sert à amener le monosilane $Si\,H_4$. Le conduit 2 transporte l'hydrogène moléculaire $H_2$. La cavité microonde 4 placée autour du conduit 2 et reliée à un générateur 9 transforme par ionisation l'hydrogène moléculaire $H_2$ en hydrogène atomique H qui est injecté dans l'enceinte 1. L'injection est de préférence réalisée par une forme en pomme d'arrosoir donnée à l'extrémité du conduit 2 qui aboutit à l'enceinte 1. Cette forme en pomme d'arrosoir contribue à créer au niveau de l'injection une légère surpression de l'hydrogène par rapport au flux de monosilane, lequel évite ainsi de pénétrer dans le conduit 2. Dans la zone hachurée 5 délimitée grossièrement par des pointillés, l'hydrogène atomique réagit sur le monosilane selon la réaction (1) donnée plus haut. Comme il a

été dit, les principaux composants qui résultent de cette réaction sont $Si_2H_6$, $Si_3$ $H_8$ et l'hydrogène moléculaire $H_2$. Toutes les espèces produites au cours de la réaction sont évacuées vers le conduit 6 qui est relié à un circuit de pompage. Le circuit de pompage contribue aussi à faire baisser la pression à l'intérieur de l'enceinte 1 jusqu'à la pression de mise en oeuvre du procédé peut être comprise entre quelques dizaines de pascals et quelques milliers de pascals. Entre le conduit 6 et la zone 5 où se forme le disilane, se trouve le réacteur qui effectue la décomposition thermique du disilane. Ce réacteur comprend un élément chauffant constitué par des spires 7 conductrices et non jointives entourant l'enceinte 1. Le passage d'un courant électrique dans les spires 7 produit et maintient, par effet joule, une température de l'ordre de 450° C ou même inférieure à 450° C et qui est suffisante pour décomposer thermiquement le disilane. Sous la référence 8, on a représenté symboliquement les échantillons à traiter qui peuvent par exemple être des substrats de verre sur lesquels on doit déposer une ou plusieurs couches de silicium amorphe. Pour une meilleure efficacité du procédé, les échantillons sont de préférence disposés perpendiculairement au flux des gaz et en une seule file.

Il est à remarquer que le silane $Si_3$ $H_8$, qui est l'une des espèces qui se dégage de la réaction (1), se décompose également pour participer au dépôt de silicium amorphe. On peut également remarquer qu'un excédent éventuel de monosilane se propageant dans le réacteur thermique, ne peut pas se décomposer puisque la température est trop basse. Cet excédent est évacué par le pompage comme les autres espèces qui ne participent pas au dépôt proprement dit.

La figure 2 représente schématiquement un dispositif de dépôt de silicium amorphe selon une variante de l'invention. Dans ce dispositif le disilane est élaboré par décomposition d'un plasma de silane. Sur la figure 2, les mêmes références que sur la figure 1 désignent les mêmes éléments. La cavité microonde 10 reliée au générateur 11 et placée autour de l'enceinte 1 assure la formation, entre autres espèces, de disilane qui sera décomposer thermiquement et à basse pression dans le réacteur thermique situé un peu plus loin.

Si l'on désire obtenir des couches de silicium amorphe dopées, il suffit, selon l'art connu, d'introduire les éléments dopants par l'intermédiaire d'un gaz (par exemple l'arsine, le diborane ou la phosphine) accompagnant le flux de silane. La proportion du gaz contenant le dopant par rapport au silane, ou à tout autre gaz vecteur, est fonction du dopage désiré.

Le procédé selon l'invention permet donc, à partir d'éléments bon marchés, d'obtenir des dépôts de silicium amorphe pour des températures relativement basses. Ceci est très avantageux lorsque les dépôts doivent être réalisés sur des substrats, tels certains verres, qui ne supportent pas les températures élevées (supérieures à 500° C).

## REVENDICATIONS

1. Procédé de dépôt de silicium amorphe sur un substrat, le dépôt étant réalisé dans un réacteur thermique dont la température de réaction est suffisante pour provoquer la décomposition thermique du disilane ($Si_2H_6$) qui est produit en amont dudit réacteur thermique, caractérisé en ce que la production de disilane est obtenue au cours de l'opération de dépôt à partir d'autres éléments de base.

2. Procédé de dépôt selon la revendication 1, caractérisé en ce que l'opération de dépôt s'effectue à pression réduite.

3. Procédé de dépôt selon l'une des revendications 1 ou 2, caractérisé en ce que les éléments de base comprennent au moins le monosilane ($Si\ H_4$).

4. Procédé de dépôt selon la revendication 3, caractérisé en ce que le disilane est engendré à partir d'un plasma de monosilane.

5. Procédé de dépôt selon la revendication 3, caractérisé en ce que le disilane est créé par action de l'hydrogène atomique sur un flux de monosilane.

6. Procédé de dépôt selon la revendication 5, caractérisé en ce que l'hydrogène atomique est obtenu par ionisation d'hydrogène moléculaire.

7. Dispositif de dépôt de silicium amorphe par un procédé de dépôt selon l'une quelconque des revendications 1 à 6, caractérisé en ce qu'il est constitué par une enceinte (1) comprenant un réacteur thermique et des moyens de chauffage (7).

FIG.1

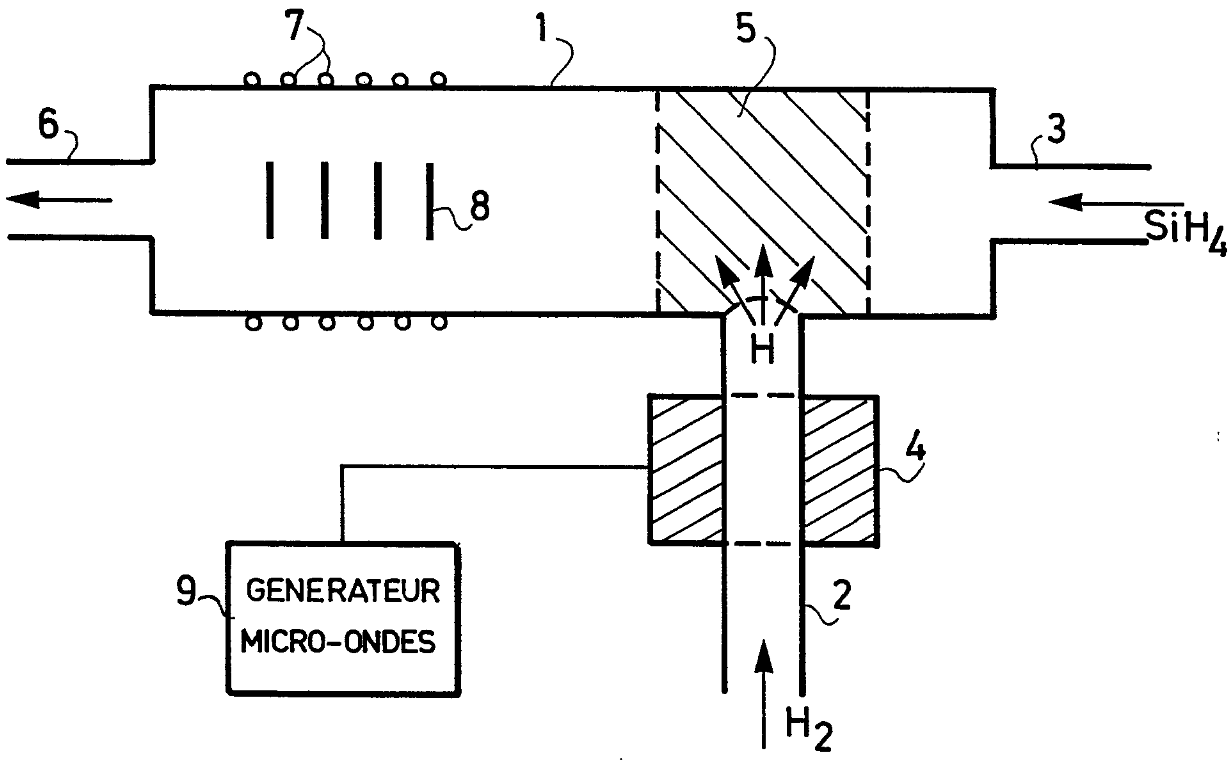
7
1
5
6
3
8
SiH4
H
4
9
GENERATEUR
MICRO-ONDES
2
H2

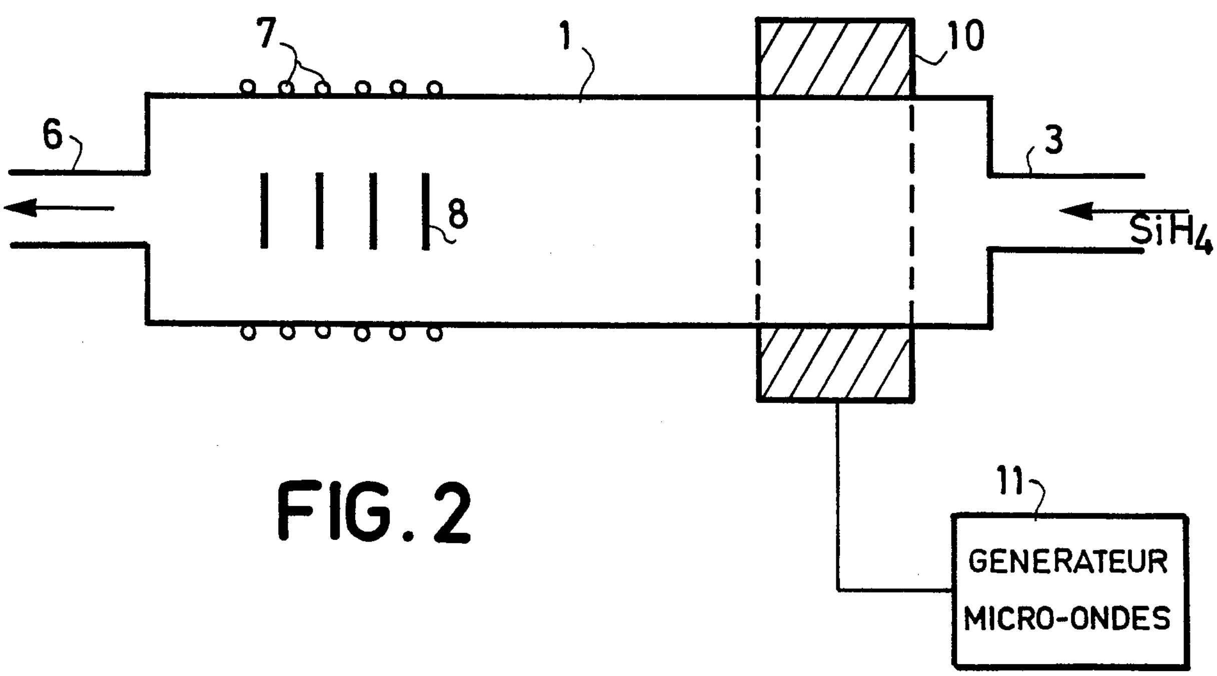
7
1
10
6
3
8
SiH4
11
GENERATEUR
MICRO-ONDES

FIG.2

Office européen des brevets

# RAPPORT DE RECHERCHE EUROPEENNE

0143701
Numéro de la demande

EP 84 40 2349

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | WO-A-8 203 069 (CHRONAR CORP.)<br>* Figure 1B; pages 7-9 *<br>--- | 1,2,7 | C 23 C 16/24 |
| A | GMELIN HANDBOOK OF INORGANIC CHEMISTRY, "Si - silicon", 8e édition, suppl. vol. B1, syst. no. 15, 1982, Springer-Verlag, Berlin, DE;<br>* Pages 176-179, 122-126, 129-139 *<br>--- | 3 | |
| A | GB-A-2 076 587 (NIPPON TELEGRAPH)<br>* Page 6, lignes 106-119 *<br>--- | | |
| A | GB-A- 942 201 (MERCK)<br>* Page 2, lignes 21-30 *<br>--- | | DOMAINES TECHNIQUES RECHERCHES (Int. Cl.4) |
| A | DE-A-1 268 600 (SIEMENS)<br>* Figure *<br>----- | | C 23 C 16/00<br>C 30 B 25/00<br>C 01 B 33/00 |

Le présent rapport de recherche a été établi pour toutes les revendications

| Lieu de la recherche | Date d'achèvement de la recherche | Examinateur |
|---|---|---|
| LA HAYE | 27-02-1985 | DEVISME F.R. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant